# EUROPEAN PATENT APPLICATION

(11) **EP 1 391 743 A1**
(43) Date of publication of application: **25.02.2004**
(21) Application number: 02078212.4
(22) Date of filing: 05.08.2002
(51) Int. Cl.: G01R 33/28

(54) **Surgical probe with MR tip tracking**

(71) Applicant: Koninklijke Philips Electronics N.V., 5621 BA Eindhoven (NL)
(72) Inventor: Gilderdale, David J., International Octrooibureau., 5656 AA Eindhoven (NL)
(74) Representative: Wolfs, Marc Johannes Maria

(57) **Abstract**

A probe such as a biopsy needle uses the needle 5, 6 as one electrode of a two electrode device which receives MR signals, during an imaging operation, in order to track its path within a patient.

## Description

This invention relates to surgical probes.

The invention especially relates to the visualisation of the tip of such a probe whilst imaging the surrounding tissue using magnetic resonance imaging.

The invention is particularly suited to surgical needles, such as biopsy needles.

Magnetic resonant imaging is a technique in which a strong magnetic field, usually termed the B₀ field, is set up in a region it is desired to image. Magnetic resonant (MR) active nuclei, typically hydrogen protons in water and fat tissue, precess about the direction of the magnetic field, and can be excited to resonance by the application of an orthogonal r.f. field, usually termed the B₁ field. The relaxation signals generated when the nuclei return to their original state can be picked up by r.f. receive coils. Magnetic field gradients typically in orthogonal directions enable to spatial location of the relaxation signals, and hence of the nuclei, to be encoded/decoded.

Existing methods for needle visualisation fall into two categories, namely, passive methods and active methods. As far as passive methods are concerned, two approaches have been used. The simplest and most popular relies on the local B₀ field disturbance resulting from the material used to construct the needle. An alternative is to rely on the local signal enhancement resulting from a small quantity of a Gadolinium compound deposited close to the needle tip. However, such methods, which rely on signal voids due to the material of the needle itself, or the local B₀ disturbance due to susceptibility mismatch with surrounding tissue, although simple, are more liable to image misrepresentation.

As far as active methods are concerned, two approaches also have been used. Both require greater hardware complexity than for the passive methods. One approach was a miniature MR receiver coil on the needle tip which contains material designed to generate a high MR signal, giving a bright spot tip marker in the image. Alternatively a small, untuned coil can be placed at the tip to carry a d.c. current producing a visible local B₀ field disturbance which may be used to locate the tip.

As far as imaging is concerned, as opposed to needle visualisation, MR probes have been built into catheters, allowing images to be obtained from within small intravascular structures. The concept of the dipole antenna being adopted for intra-vascular imaging was introduced by Ocali and Atalar (MRM, 37; 112, 1997). This device was operated in the usual ½-wavelength resonant mode, the main innovation from a practical viewpoint being to adopt the 'flag-pole' structure (Terman F E "Electronic and Radio Engineering" page 902, McGraw-Hill (1995)) so as to allow the probe to be operated as essentially a one-dimensional device, the feeder being a continuation of the probe.

It might be assumed that such a dipole antenna could be used to assist visualisation of a needle tip. However, as a device for highlighting a needle tip, the half-wavelength dipole structure would have the disadvantage that current and hence MR sensitivity would be minimum at the device tip. The position of the tip would therefore not separately highlighted, rather its position would have to be inferred from the disappearance of signal. Also, since the whole length of the probe is part of a resonant structure, device size may impose an unacceptable restriction if this technique is applied to a needle.

The invention provides a surgical probe, the tip of which forms one electrode, which includes a second electrode spaced from the needle in use by the medium in which the probe is inserted to form a conductive loop for receiving magnetic resonance signals.

The invention ensures that the probe is highlighted without the addition of delicate electronic components close to the tip. Thus, the probe can be both simple to manufacture and robust.

The invention will now be described in detail, by way of example, with reference to the accompanying drawings, in which:
Figure 1 is a schematic view of a biopsy needle in accordance with the invention;
Figure 2 is an axial sectional view of the tip region of the biopsy needle in accordance with the invention;
Figure 3 is an enlarged view of a part of the biopsy needle shown in Figure 2;
Figure 4 is a side view of a region along the length of the biopsy needle shown in Figure 2;
Figure 5 is a schematic view of a second form of needle in accordance with the invention; and
Figure 6 is a schematic view of a modified form of the needle of Figure 5.

The aim of the invention is to permit visualisation of the tip of a biopsy needle 1, mounted in a holder 2, when inserted into tissue 3 of a patient (Figure 11), while at the same time being able to perform magnetic resonance imaging of the tissue. A problem with such biopsy needles is that they can bend due to meeting a tougher area of tissue. Markers on the holder have been previously used to indicate the position of the tip by calculation, but this would merely indicate the dotted path 4 corresponding to an undistorted needle.

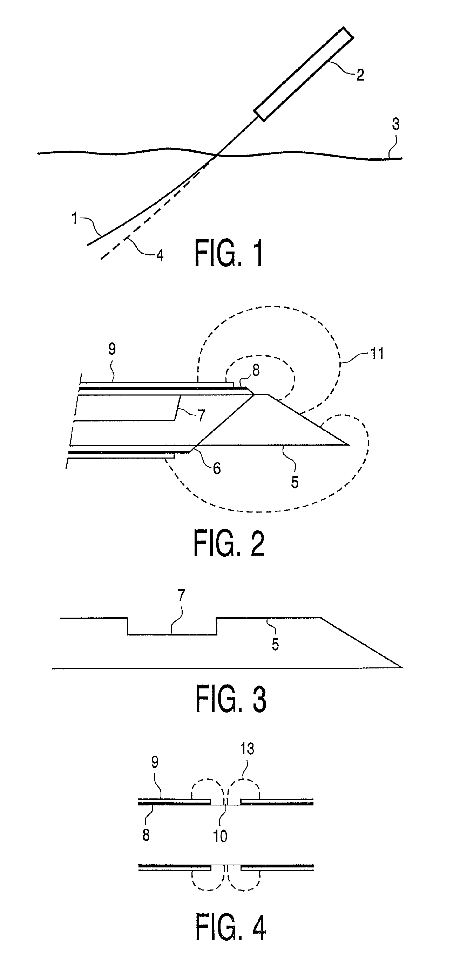

A biopsy needle consists of an inner cannula 5 which is slidable within an outer cannula 6. The inner cannula is solid and has a flat 7 formed in it. In operation, the biopsy needle is inserted into the patient with the inner and outer cannulas positioned as in Figure 2. A trigger is released by the operator, which fires the inner cannula a short distance into the patient, and the outer cannula then travels forward to return to its original position relative to the inner cannula. This traps a mass of tissue in the flat. The tissue can be removed for analysis by withdrawal of the needle.

In accordance with the invention, the outer cannula 6 is coated by insulation 8 in the form of two layers of insulating varnish, on top of which a conducting layer 9, in the form of a layer of copper foil, is mounted.

The tip of the inner cannula 5 extends beyond the conducting layer by a distance of approximately 0.5cm. This is an order of magnitude less than one quarter-wavelength at the magnetic resonance frequency, since the latter is 60MHz at which one quarter-wavelength is around 14cm.

If the coaxial structure thus formed was driven with an r.f. current, currents such as shown by dotted lines 11 would be produced. By reciprocity, such dotted lines represent the sensitive region over which the probe tip would collect magnetic resonance signals. A magnetic resonance image of the patient would thus highlight the tip of the needle. The needle does not suffer from the disadvantage of a quarter-wavelength dipole structure that the MR sensitivity is a minimum of the device tip. The field of view is much more localised.

The output of the signal collected by the biopsy needle appears between the coaxial layers of the conducting layer 9 and the cannulas 5, 6 at the end of the needle. In order to optimise pre-amplifier performance, the output impedance is transformed to 50 ohms. Also, the probe impedance, as seen from the imaged medium, is forced to as high a value as possible, to minimise circulating currents during B₁ (r.f. excitation pulse) excitation. Both these impedance conversions are performed using surface mount circuitry provided at the junction of the needle and the holder. In order to provide MR sensitivity along the length of the needle, at various positions along the length of the needle (Figure 4), annular regions of the insulating material 8 and the conducting layer 9 are cut away 10. This provides additional marker highlights 13 in the MR image.

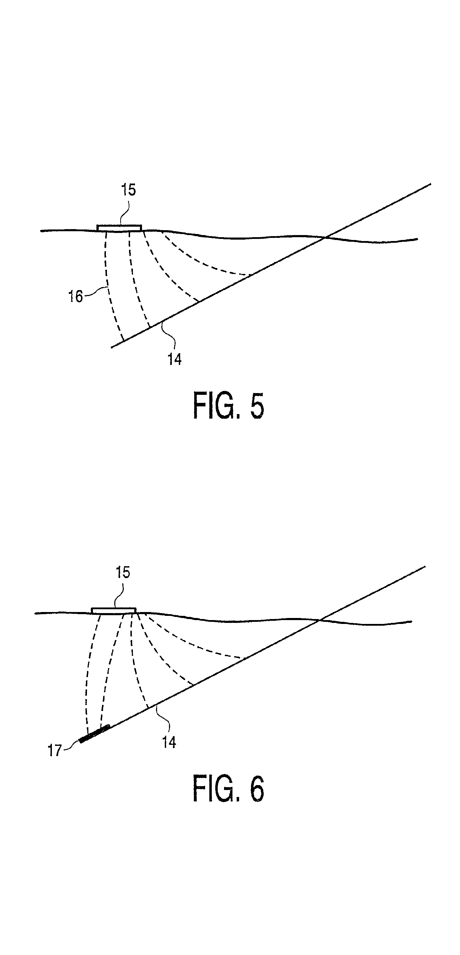

In an alternative two electrode form (Figures 5 and 6), a needle 14, which need not be a biopsy needle, forms one electrode, whilst the second is provided by a conductive pad 15 in contact with the skin. This arrangement provides a larger field of view, but fails to highlight the tip well since this is a point of minimum sensitivity 16.

The tip visibility is improved (for 21.3MHz) by applying a layer of insulation 17 to the needle surface except for a region approximately 5mm close to the tip. Thus, conduction current (but not capacitive current) is eliminated in these regions, but tip visualisation is still inferior to the coaxial embodiment.

The lengths of the needles shown in Figures 5 and 6 is approximately 15cm, compared to 42cm for a quarter-wavelength.

In a further embodiment, the needles can also be driven to produce an electric field which would produce heating in the lossy medium of tissue. Thus, the needles (or, more generally, probes) could be used to provide tracking due to the tip highlighting. A larger r.f. coil could be used in conjunction to provide a greater field of view. Then, when a tumour has been located, the electric current could be switched on to destroy the tumour by ablation.

The invention is applicable to any form of needle, biopsy or otherwise, or any form of probe.

## Claims

1. A surgical probe, the tip of which forms one electrode, which includes a second electrode spaced from the needle in use by the medium in which the probe is inserted to form a conductive loop for receiving magnetic resonance signals.

2. A surgical probe as claimed in claim 1, in which the second electrode is formed by a conducting layer separated from the surface of the probe by an insulating layer.

3. A surgical probe as claimed in claim 2, in which the tip projects beyond the conducting layer.

4. A surgical probe as claimed in claim 3, in which the tip projects beyond the conducting layer by a distance which is less than one fifth of a quarter wavelength at the magnetic resonance frequency.

5. A surgical probe as claimed in claim 4, in which the tip projects beyond the conducting layer by a distance which is less than one tenth of a quarter wavelength at the magnetic resonance frequency.

6. A surgical probe as claimed in claim 1, in which the second electrode is a pad for application to the skin of the patient in the vicinity of the location at which the needle is inserted.

7. A surgical probe as claimed in any one of claims 1 to 6, in which the probe is a needle.

8. A surgical probe as claimed in claim 7, in which the needle is a biopsy needle.

9. A surgical probe as claimed in any one of claims 1 to 7, in which the probe is also capable of transmitting for ablation purposes.
